# DEMANDE DE BREVET EUROPEEN

(11) **EP 0 607 464 A1**
(43) Date de publication de la demande: **27.07.1994**
(21) Numéro de dépôt: 92402498.7
(22) Date de dépôt: 11.09.1992
(51) Int. Cl.: G01R 15/12

(54) **Dispositif d'acquisition de mesures multifonction**

(71) Demandeur: SOCIETE MARECHAUX DUBOST INSTRUMENTS S.A., F-78290 Croissy-sur-Seine (FR)
(72) Inventeur:
(74) Mandataire: Launier, André

(57) **Abrégé**

L'invention concerne un dispositif d'acquisition de mesures multifonction, caractérisé en ce qu'il comprend une pluralité de capteurs (notamment 21 à 26) relatifs à plusieurs grandeurs physiques différentes, chacun comprenant des moyens d'identification agencés pour fournir une première information d'identification, représentative de la nature de la grandeur physique concernée, et des moyens transducteurs agencés pour fournir une seconde information, représentative de la valeur de cette grandeur physique et fournie sous la forme d'une grandeur électrique ; et une unité de traitement (20) agencée pour coopérer avec l'un quelconque desdits capteurs (21 à 26), comprenant des moyens d'interprétation agencés pour interpréter ladite première information d'identification, et des moyens de traitement agencés pour transformer ladite grandeur électrique en une grandeur électrique unique de référence en fonction de ladite première information d'identification.

## Description

L'invention concerne un dispositif d'acquisition de mesures multifonction, caractérisé en ce qu'il comprend une pluralité de capteurs relatifs à plusieurs grandeurs physiques différentes, chacun comprenant des moyens d'identification agencés pour fournir une première information d'identification, représentative de la nature de la grandeur physique concernée, et des moyens transducteurs agencés pour fournir une seconde information, représentative de la valeur de cette grandeur physique et fournie sous la forme d'une grandeur électrique ; et une unité de traitement agencée pour coopérer avec l'un quelconque desdits capteurs, comprenant des moyens d'interprétation agencés pour interpréter ladite première information d'identification, et des moyens de traitement agencés pour transformer ladite grandeur électrique en une grandeur électrique unique de référence en fonction de ladite première information d'identification.

D'autres détails et avantages de l'invention apparaîtront au cours de la description suivante d'une forme préférée de réalisation mais non limitative, en regard des dessins annexés, sur lesquels :
La figure 1 représente le dispositif d'acquisition de mesures selon l'invention et les éléments destinés à le compléter ;
La figure 2 est une vue en élévation et en coupe longitudinale d'une unité de traitement faisant partie du dispositif d'acquisition de mesures ;
La figure 3 est une vue de côté de l'unité de traitement de la figure 2 ;
La figure 4 est un circuit électronique de l'unité de traitement ;
La figure 5 est un circuit électronique constituant une partie du circuit de la figure 4 ;
La figure 6 est un circuit électronique d'un capteur d'intensité inductif ;
La figure 7 est un circuit électronique d'un capteur de haute tension ;
La figure 8 est un circuit électronique d'un capteur d'humidité ;
La figure 9 est un circuit électronique d'un capteur d'intensité à effet Hall ;
La figure 10 est un circuit électronique d'un capteur de lumière ;
La figure 11 est un circuit électronique d'un capteur de température ; et
La figure 12 est un circuit électronique d'un capteur anémométrique.

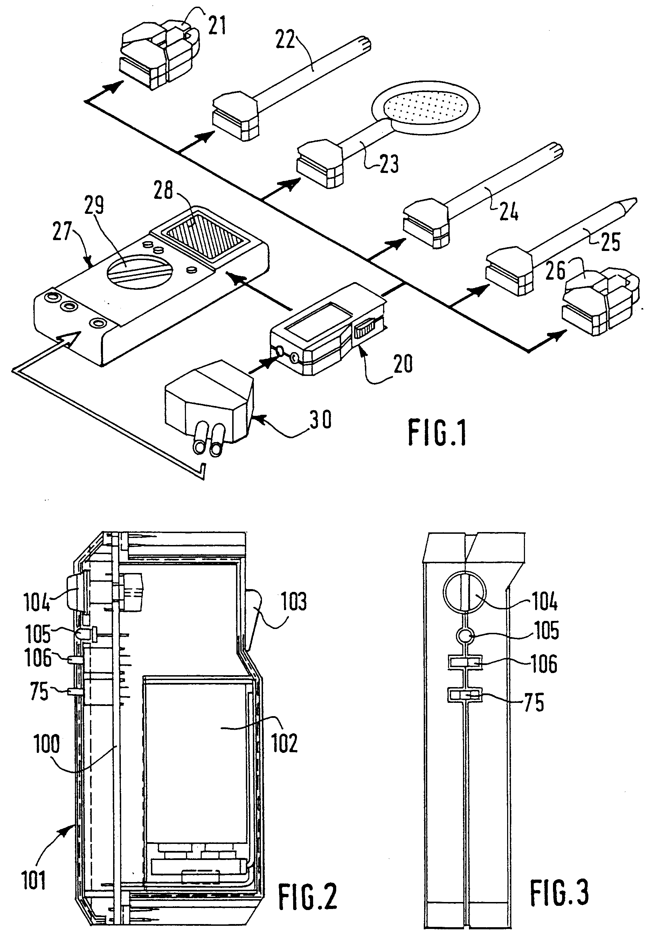

Le dispositif d'acquisition de mesures représenté sur la figure 1 comprend une unité de traitement 20 destinée à être reliée électriquement à l'un de plusieurs capteurs tels qu'un capteur d'intensité inductif 21 comprenant une pince ampèremétrique, un capteur de température 22, un capteur de lumière 23, un capteur d'humidité 24, un capteur de haute tension 25 et un capteur d'intensité à effet Hall comprenant une pince ampèremétrique. A cet effet, chaque capteur est pourvu d'un connecteur électrique multibroche non représenté en détail, pouvant être enfiché dans un connecteur électrique multibroche d'entrée équipant l'unité de traitement 20.

Comme précisé par la suite, l'unité de traitement est agencée pour alimenter le cas échéant le capteur dont elle est équipée à un moment donné et en tout cas traite un signal électrique reçu de ce capteur sous la forme d'un courant ou d'une tension. Le traitement consiste à délivrer, à une sortie de l'unité de traitement et quelque soit le signal électrique reçu du capteur, un signal électrique de nature unique, en l'espèce une tension continue analogique.

Un connecteur de sortie de l'unité de traitement permet de relier celle-ci à un multimètre 27 connu en lui-même et comprenant des moyens d'affichage 28 du signal électrique reçu et des moyens de calibrage 29 permettant de sélectionner une échelle adaptée à la grandeur à afficher. Avantageusement, un boîtier ou sabot 30 est monté de façon enfichable à une extrémité inférieure de l'unité de traitement 20. Il porte un connecteur agencé pour délivrer des signaux de sortie de l'unité de traitement. Il a une première fonction ergonomique puisque, par sa forme, il favorise la préhension de l'unité de traitement par un utilisateur. Il peut avoir pour seconde fonction de fournir un espace pour loger un accessoire quelconque de l'unité de traitement. Il peut notamment s'agir d'un enrouleur comprenant un câble électrique à deux conducteurs lui permettant d'être relié à distance au multimètre 27. Il peut aussi s'agir de moyens d'enregistrement de données de type électronique ou informatique, par exemple des moyens assurant une interface avec un ordinateur compatible IBM-PC.

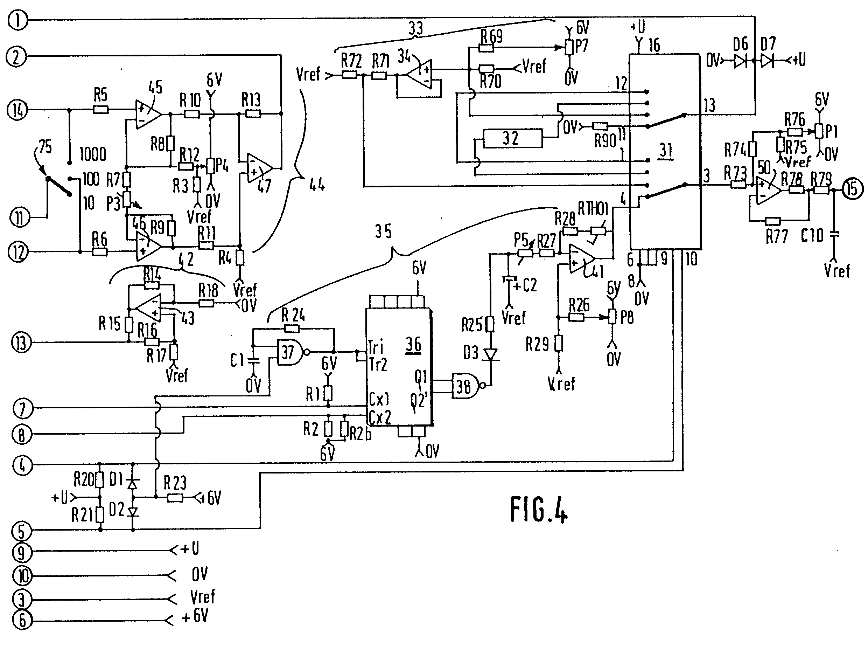

Sur la figure 4, le connecteur d'entrée de l'unité de traitement 20 comprend quatorze bornes numérotées de 1 à 14 et son connecteur de sortie comprend deux bornes dont une borne 15 délivrant ladite tension continue et une seconde borne constituée par une tension de référence, ces bornes étant entourées d'un cercle sur la figure 4.

Les bornes 9, 10, 3, 6 délivrent respectivement des tensions de référence +U, OV (zéro volt), Vref et +6V aux capteurs qui en ont besoin. La borne 1 sert, sauf en ce qui concerne le capteur d'humidité, à acheminer un signal électrique issu des capteurs et représentatif d'une grandeur physique à mesurer. Elle est reliée à un double multiplexeur analogique 31 présentant deux bornes de sortie 13, 3 pouvant être reliées électroniquement et respectivement à deux groupes de quatre bornes d'entrée 12, 14, 15, 11 et 1, 5, 2, 4, les bornes de sortie 13, 3 étant reliées simultanément et respectivement aux bornes (12, 1), (14, 5), (15, 2), ou (11, 4), en fonction de l'état électrique de deux bornes de commande 9, 10 du multiplexeur 31. Entre la borne 13 du multiplexeur 31 et deux tensions de référence OV et +U, sont montées respectivement deux diodes D6, D7.

Les bornes de commandes 9, 10 du multiplexeur 31 sont reliées respectivement aux bornes 4, 5 de l'unité de traitement. En parallèle sur les bornes 4, 5 de l'unité de traitement sont montés d'une part un ensemble de deux résistances R20 et R21 en série et d'autre part un ensemble de deux diodes D1, D2 montées tête-bêche. Un point commun aux deux résistances est relié à la tension de référence +U tandis qu'un point commun aux deux diodes est relié à la tension de référence +6V par l'intermédiaire d'une résistance R23.

Le multiplexeur 31 reçoit une tension de référence +U à une borne 16 et une tension de référence OV à ses bornes 6 à 9. Ses deux bornes d'entrée 12, 1 sont directement reliées entre elles tandis que ses bornes d'entrée 14, 5 sont reliées entre elles par l'intermédiaire d'un circuit de traitement du signal d'un capteur anémométrique 32 décrit en détail par la suite. La borne d'entrée 15 du multiplexeur est reliée à la borne d'entrée 2 par un circuit d'amplification 33 comprenant un amplificateur opérationnel 34 monté en amplificateur suiveur. Une borne d'entrée positive de celui-ci est reliée à la borne d'entrée 15 du multiplexeur, à la tension de référence Vref par une résistance R70, et à un curseur mobile d'un potentiomètre P7 par une résistance R69 ; le potentiomètre P7 comporte deux bornes fixes reliées respectivement aux deux tensions de références OV et +6V.

Une sortie de l'amplificateur opérationnel 34 est reliée à la tension de référence Vref par deux résistances en série R71, R72. Un point commun à ces deux résistances est relié à la borne d'entrée 2 du multiplexeur.

La borne d'entrée 11 du multiplexeur est reliée à la tension de référence OV par une résistance R90 tandis que la borne d'entrée correspondante 4 est reliée à un circuit de traitement 35 du signal du capteur d'humidité.

Ce circuit de traitement comprend une bascule monostable 36 recevant, à deux entrées CX1, CX2 reliées aux bornes 7 et 8 de l'unité de traitement, un signal en provenance du capteur d'humidité. L'entrée CX1 est reliée à la tension de référence +6V par une résistance R1 et l'entrée CX2 y est reliée par deux résistances en parallèle R2, R2b. La bascule monostable 36 est par ailleurs reliée à la tension de référence +6V par ses bornes 3, 5, 11, 13, 16 et à la tension de référence OV par ses bornes 1, 15, 8. Une porte NON-ET 37 montée en oscillateur présente une entrée reliée à un point commun des diodes D1, D2 précitées, et une autre entrée reliée d'une part à la tension de référence OV par un condensateur C1 et d'autre part à une sortie de la porte NON-ET par une résistance R24. Cette sortie est reliée à deux entrées Tr1, Tr2 de la bascule monostable 36.

Deux sorties Q1, Q'2 de la bascule monostable 36 sont reliées à deux entrées d'une porte NON-ET 38 dont une sortie est reliée, via une diode D3, une résistance R25, un potentiomètre P5 et une résistance R27 en série, à l'entrée inverseuse d'un amplificateur opérationnel 41 monté en amplificateur inverseur. Une borne commune à la résistance R25 et au potentiomètre P5 est reliée à la tension de référence Vref par un condensateur C2. Une entrée non inverseuse de l'amplificateur 41 est reliée à la tension de référence Vref par une résistance R29 et à un curseur mobile d'un potentiomètre P8 par une résistance R26. Ce potentiomètre comporte deux bornes fixes reliées respectivement aux tensions de références +6V et OV.

Une sortie de l'amplificateur 41 est reliée d'une part à une borne d'entrée 4 du multiplexeur 31, et d'autre part à l'entrée inverseuse de l'amplificateur par une résistance R28 montée en série avec une thermistance RTH01.

Le capteur d'humidité est habituellement constitué d'une membrane non conductrice et d'électrodes enduites d'or qui forment un condensateur dont la valeur dépend de l'humidité relative de l'air ambiant et augmente avec celle-ci. Ce condensateur, branché comme précisé par la suite sur l'unité de traitement, fait varier une largeur d'impulsions produites par la bascule monostable 36 ; la valeur du condensateur n'étant pas égale à zéro lorsque l'humidité est nulle, on vient soustraire aux impulsions produites en sortie de la bascule monostable 36 pour une humidité nulle, un créneau de largeur égale à celle de ces impulsions.

Des impulsions négatives produites par la porte NON-ET 38 sont intégrées par le condensateur C2. L'alimentation de la bascule monostable 36 et de la porte NON-ET 37 au moyen de la tension de référence +6V garantit la stabilité de ces composants. Four éviter une consommation inutile et d'éventuelles perturbations, la porte NON-ET 37 est inhibée lorsque le capteur d'humidité n'est pas utilisé.

Une source de courant 42 comprend un amplificateur opérationnel 43 dont l'entrée inverseuse est reliée d'une part à la tension de référence OV par une résistance R18, et d'autre part à une sortie de l'amplificateur par une résistance R14. Son entré non-inverseuse est reliée d'une part à la tension de référence Vref, d'autre part à la sortie de l'amplificateur par deux résistances en série R16, R15. Un point commun à ces deux résistances est relié à la borne d'entrée 13 de l'unité de traitement. Cette source de courant 42 est destinée à alimenter le capteur d'intensité à effet Hall.

Comme précisé par la suite, le capteur d'intensité à effet Hall délivre une tension proportionnelle au courant à mesurer, qui est elle-même mesurée au moyen d'un amplificateur différentiel 44. Celui-ci comprend deux amplificateurs opérationnels 45, 46 reliés respectivement à deux bornes d'entrée 14, 12 de l'unité de traitement par deux résistances R5, R6, depuis leur entrée non-inverseuse. Leurs entrées inverseuses sont reliées entre elles par une résistance R7 et un potentiomètre R3 montés en série et reliées à une sortie de l'amplificateur par une résistance R8, R9. L'entrée inverseuse de l'amplificateur 45 est reliée par une résistance R12, d'une part à la tension de référence Vref par une résistance R3, d'autre part à un curseur mobile d'un potentiomètre P4. Celui-ci comporte deux bornes fixes reliées respectivement aux deux tensions de référence OV et +6V.

Un troisième amplificateur opérationnel 47 présente une entrée inverseuse et une entrée non-inverseuse reliées respectivement aux sorties des amplificateurs 45, 46 par deux résistance R10, R11. Son entrée inverseuse est reliée, ainsi qu'une sortie de l'amplificateur, à la borne d'entrée 2 de l'unité de traitement, tandis que son entrée non-inverseuse est reliée à la source de tension Vref par une résistance R4. Une tension présente à cette borne d'entrée 2 est transmise à la borne d'entrée 1 de l'unité de traitement au moyen d'un potentiomètre situé dans le capteur d'intensité à effet Hall.

Un amplificateur opérationnel 50 monté en amplificateur non-inverseur présente une entrée non-inverseuse reliée, d'une part par une résistance R73 à la borne de sortie 3 du multiplexeur, et d'autre part à un curseur mobile d'un potentiomètre P1 par deux résistances R74, R76 montées en série. Un point commun à ces deux résistances est relié à la tension de référence Vref par une résistance R75. Deux bornes fixes du potentiomètre P1 sont reliées aux deux tensions de référence OV, +6V.

Une entrée inverseuse de l'amplificateur 50 est reliée à une sortie de celui-ci par deux résistances R77, R78 montées en série. La borne de sortie 15 de l'unité de traitement est reliée, d'une part à un point commun aux deux résistances R77, R78 par une résistance R79, d'autre part à la tension de référence Vref par un condensateur C10.

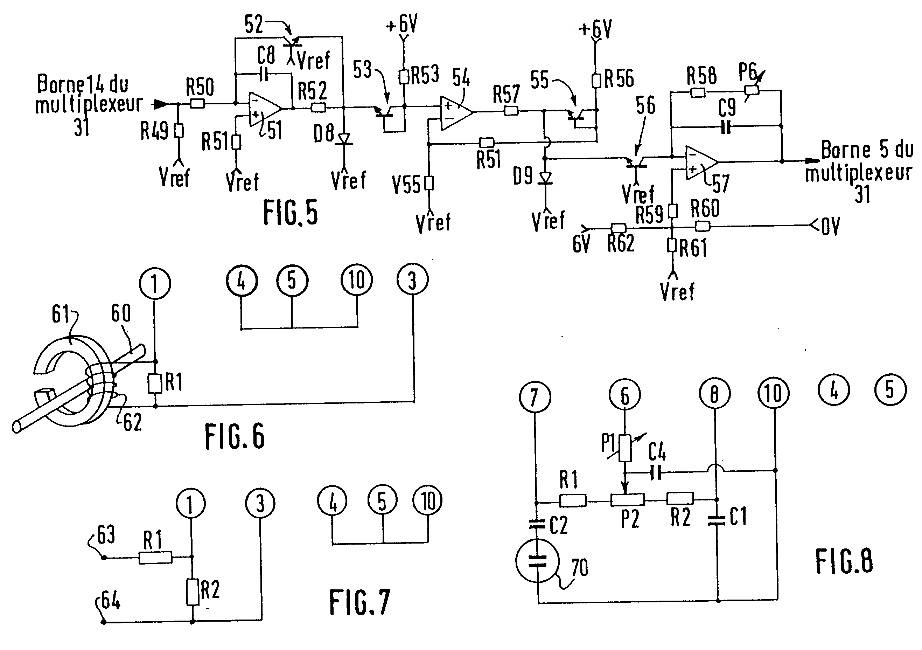

Sur la figure 5 est représenté le circuit de traitement du signal provenant du capteur anémométrique, c'est-à-dire du capteur capable d'indiquer la vitesse d'écoulement d'un fluide tel que l'air. Ce signal n'étant pas directement proportionnel à cette vitesse, il est traité par un amplificateur logarithmique réalisant une élévation mathématique à une puissance. Cet amplificateur inclut un amplificateur opérationnel 51 et deux transistors NPN 52 et 53.

Une entrée inverseuse de l'amplificateur opérationnel 51 est reliée par une résistance R50 à la borne 14 du multiplexeur 31, cette même borne étant reliée à la tension de référence Vref par une résistance R49. Cette entrée inverseuse est également reliée, d'une part à une sortie de l'amplificateur 51 au moyen d'un condensateur C8, d'autre part au collecteur du transistor 52 dont la base est reliée à la tension de référence Vref et dont l'émetteur est relié à la sortie de l'amplificateur 51 par l'intermédiaire d'une résistance R52. Une entrée non-inverseuse de l'amplificateur 51 est reliée à la tension de référence Vref par l'intermédiaire d'une résistance R51. A l'émetteur du transistor 52 sont reliés d'une part la tension de référence Vref par l'intermédiaire d'une diode D8, d'autre part l'émetteur du transistor 53 dont la base et le collecteur sont reliés à la tension de référence +6V par une résistance commune R53.

Un amplificateur opérationnel 54 introduit un gain qui fixe l'élévation à la puissance produite par l'amplificateur logarithmique précédent. Il présente une entrée non-inverseuse reliée au collecteur du transistor 53 et une entrée inverseuse reliée à la tension de référence Vref par une résistance R55. Une sortie de l'amplificateur 54 est reliée à l'émetteur d'un transistor NPN 55 par une résistance R57. La base et le collecteur de ce dernier transistor sont reliés entre eux et reliés, d'une part à la tension de référence +6V par une résistance 56 et d'autre part à l'entrée inverseuse de l'amplificateur opérationnel 54 par une résistance R54. Enfin l'émetteur du transistor 55 est relié à la tension de référence Vref par une diode D9.

Le circuit de la figure 5 comprend un dernier amplificateur opérationnel 57. Une entrée inverseuse de cet amplificateur est reliée au collecteur d'un dernier transistor NPN 56 dont la base est reliée à la tension de référence Vref et dont l'émetteur est relié à l'émetteur du transistor 55 précédent. Cette entrée inverseuse est également reliée à la sortie de l'amplificateur 57 d'une part par un condensateur C9, d'autre part par une résistance 58 montée en série avec un potentiomètre P6, ces deux éléments étant disposés en parallèle sur le condensateur C9. Une entrée non-inverseuse de l'amplificateur 57 est reliée, par deux résistances R59 et R61 montées en série, à la tension de référence Vref. Un point commun aux deux résistances précitées est relié par l'intermédiaire d'une résistance R62 à la tension de référence +6V, et par une résistance R60 à la tension de référence 0V. Enfin la sortie de cet amplificateur est reliée à la borne 5 du multiplexeur 31.

L'unité de traitement étant ainsi définie, il s'agit maintenant de décrire chaque capteur et le circuit électronique que celui-ci comporte. Ce circuit électronique remplit plusieurs fonctions. Dans le cas où le capteur utilisé exige une alimentation en électricité, ce circuit réalise une connexion appropriée avec des sources de tension ou de courant prévues dans l'unité de traitement. Ce circuit électronique permet également de rattraper la dispersion des valeurs nominales des capteurs de façon à rendre ceux-ci interchangeables vis-à-vis de l'unité de traitement. Enfin, il permet de commander le multiplexeur 31 de l'unité de traitement sur une position correspondant au type de capteur concerné.

La figure 6 représente le circuit électronique du capteur d'intensité inductif. Un courant traversant un conducteur rectiligne 60 étant à mesurer, un circuit magnétique 61 permet de guider un champ électrique produit par le courant. Un courant induit dans une bobine 62 disposée autour du circuit magnétique 61 est converti en une tension électrique au moyen d'une résistance R1 disposée aux bornes de la bobine 62. Le connecteur de sortie de chaque capteur est agencé pour coopérer avec le connecteur d'entrée de l'unité de traitement. Ses bornes effectivement reliées au circuit électronique du capteur portent un numéro identique à la borne du connecteur de l'unité de traitement avec laquelle elles doivent coopérer. Dans cet exemple, les bornes de la bobine 62 sont reliées aux bornes 1 et 3 du connecteur. Les bornes 4, 5 et 10 sont reliées entre elles, ce qui a pour effet de mettre les bornes de commande 9, 10 du multiplexeur 31 au potentiel 0, et de relier les bornes de sortie 13, 3 du multiplexeur avec les bornes d'entrée 12 et 1 de celui-ci respectivement.

La figure 7 est un circuit électronique d'un capteur de haute tension capable de prélever une haute tension présente entre deux bornes 63 et 64. Un diviseur de tension constitué par deux résistances R1 et R2 permet de ramener sur les bornes 1 et 3 du connecteur une tension de valeur réduite. Les bornes 4, 5 et 10 sont reliées de la même manière que dans le cas de la figure 6, de sorte que le multiplexeur 31 est dans le même état électronique.

Le circuit électronique du capteur d'humidité représenté sur la figure 8 comprend une boucle constituée par plusieurs composants électroniques disposés en série, à savoir un condensateur C1, une humidistance 70 formant elle-même un condensateur, un condensateur C2, une résistance R1, un potentiomètre P2 monté entre deux bornes fixes, et une résistance R2. Un point commun entre la résistance R1 et le condensateur C2 est relié à la borne 7 du connecteur du capteur, tandis qu'un curseur mobile du potentiomètre P2 est relié à une borne 6 du connecteur par un potentiomètre P1. La borne 10 du connecteur est reliée d'une part à ce curseur par un condensateur C4, et d'autre part à un point commun entre le condensateur C1 et l'humidistance 70. La borne 8 du connecteur est reliée à un point commun entre la résistance R2 et le condensateur C1. Par ailleurs les bornes 4 et 5 du connecteur ne sont pas reliées, ce qui a pour effet de placer le multiplexeur 31 dans l'état représenté sur la figure 4, dans lequel ses bornes de sortie 13 et 3 sont reliées à ses bornes d'entrée 11 et 4 respectivement.

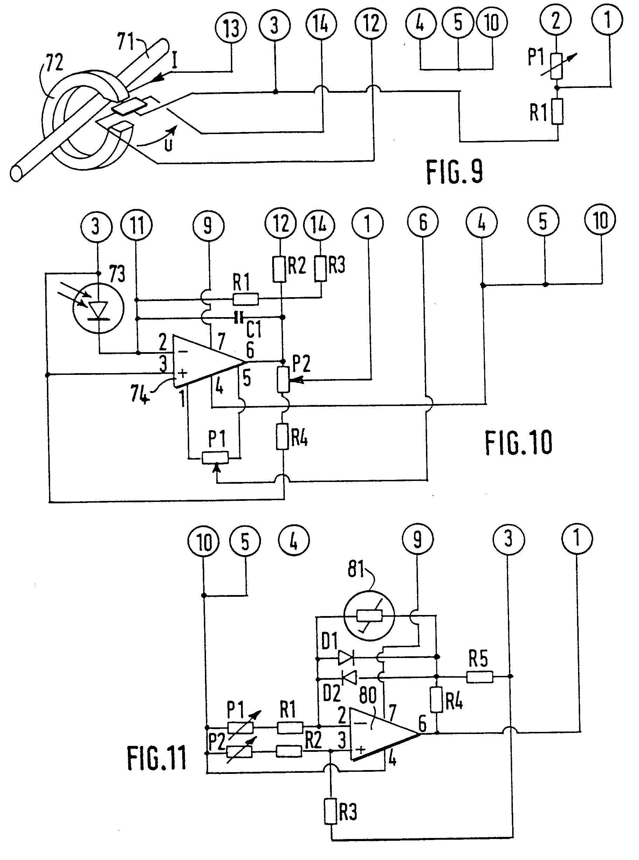

Dans le circuit électronique du capteur d'intensité à effet Hall de la figure 9, un conducteur électrique 71 parcouru par un courant à mesurer engendre un champ magnétique dans lequel baigne un circuit magnétique 72. Si l'on place dans un entrefer du circuit magnétique 72 une plaquette en un matériau particulier tel que le germanium ou 1e sélénium, cette plaquette étant parcourue par un courant I, l'action du champ magnétique qui traverse la plaquette fait apparaître entre deux extrémités de celle-ci une tension U représentative du courant à mesurer. Le courant I, injecté dans le capteur par la borne 13 de son connecteur, retourne à l'unité de traitement par la borne 3. La tension U est récupérée aux bornes 14 et 12 du connecteur du capteur. Les bornes 4, 5 et 10 du connecteur du capteur sont reliées entre elles, ce qui a pour effet de placer le multiplexeur 31 dans une position dans laquelle ses bornes de sortie 13, 3 sont reliées respectivement à ses bornes d'entrée 15, 2. les bornes 1 et 2 du connecteur du capteur sont reliées entre elles par un potentiomètre P1, et la borne 1 est reliée à la borne 3 par une résistance R1.

Le circuit électronique du capteur de lumière représenté à la figure 10 comprend une photodiode 73 incluant un filtre centré sur une longueur d'onde de 550 microns, donc sur la lumière visible, et possède une réponse identique à celle de l'oeil humain. Cette photodiode 73 est branchée entre les bornes d'entrée 3 d'un amplificateur opérationnel 74 qui réalise une conversion courant/tension. Un condensateur C1 et une résistance R1 sont chacun montés entre l'entrée inverseuse 2 de l'amplificateur et une sortie 6. L'entrée non-inverseuse 3 de l'amplificateur est reliée à sa sortie 6 par une résistance R4 montée en série avec un potentiomètre P2 par des bornes fixes de celui-ci. Un curseur mobile du potentiomètre P2 est relié à une borne 1 du connecteur du capteur. Les bornes 12 et 14 du capteur sont chacune reliées par une résistance R2, respectivement R3, à la sortie 6 de l'amplificateur 74. Une borne 11 du capteur est reliée à l'entrée inverseuse 2 de l'amplificateur 74. La borne 11 conduit à un commutateur 75 disposé dans l'unité de traitement (figure 4) permettant d'effectuer un calibrage du niveau du signal par multiplication par des facteurs égaux à 10 LUX, 100 LUX et 1000 LUX. Une borne d'alimentation 7 de l'amplificateur 74 est reliée à la borne 9 du connecteur du capteur, tandis qu'une borne d'alimentation 4 de ce même amplificateur est reliée à la borne 10 du connecteur du capteur. Deux autres bornes d'alimentation de l'amplificateur 74 désignées par 1 et 5 sont reliées entre elles par un potentiomètre P1 monté entre ses bornes fixes, tandis qu'un curseur mobile de ce potentiomètre est relié à une borne 6 du connecteur du capteur. Les bornes 4 et 5 du connecteur du capteur sont reliées à la borne 10, ce qui a pour effet de placer le multiplexeur 31 dans une position dans laquelle ses bornes de sortie 13, 3 sont respectivement reliées à ses bornes d'entrée 14, 5.

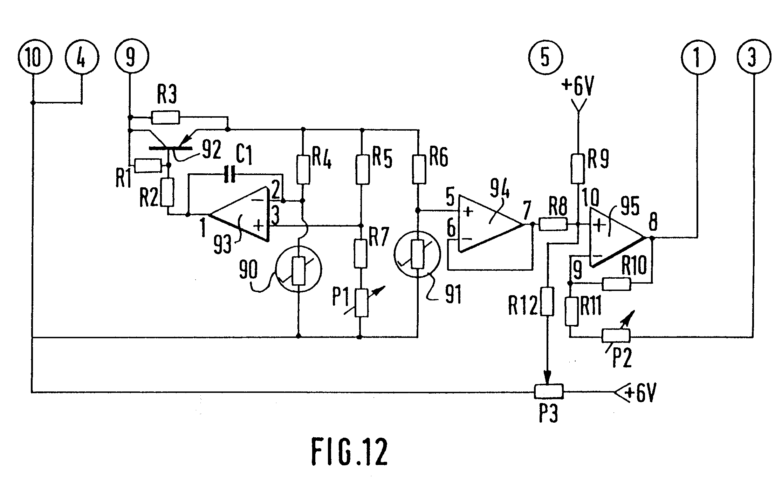

Le circuit électronique du capteur de température, représenté sur la figure 11, comprend un amplificateur opérationnel 80 dont une entrée inverseuse 2 est reliée à une borne 10 du connecteur du capteur par une résistance R1 et un potentiomètre P1, tandis qu'une entrée non-inverseuse 3 de cet amplificateur est reliée, par une résistance R2 et un potentiomètre P2, à cette même borne 10. Entre l'entrée inverseuse 2 de l'amplificateur 80 et sa sortie 6, sont montés une résistance R4 en série avec un ensemble comprenant trois composants en parallèle, à savoir une sonde de température 81 portant la référence commerciale PT 100, et deux diodes D1, D2 montées tête-bêche. Un point commun entre la résistance R4 et ledit ensemble est relié à une borne 3 du connecteur du capteur par une résistance R5. L'entrée non-inverseuse 3 de l'amplificateur 80 est reliée à cette même borne 3 du connecteur du capteur par une résistance R3. La sortie 6 de l'amplificateur 80 est reliée directement à une borne 1 du connecteur du capteur. Des entrées d'alimentation de l'amplificateur 80, respectivement référencées 4 et 7, sont reliées d'une part à la borne 10 et d'autre part à la borne 9 du connecteur du capteur. La borne 5 du connecteur du capteur est reliée à sa borne 10 tandis que sa borne 4 est en l'air, ce qui a pour effet de placer le multiplicateur 31 dans une position dans laquelle ses bornes de sortie 13, 3 sont reliées avec ses bornes d'entrée 15, 2.

La sonde de température 81, dont la variation est linéaire à ± 0,1°C près, entre -10°C et 70°C, est traversée par un courant constant. On obtient donc une conversion résistance/tension en sortie de l'amplificateur 80. Les composants P2, R2, R3 permettent un décalage à l'origine de manière à compenser la résistance de la sonde à 0°C.

Le circuit électronique d'un capteur anémométrique est représenté sur la figure 12. Le circuit comprend un ensemble résistif constitué de trois branches disposées en parallèle. Une première branche comprend une résistance R4 montée en série avec une thermistance 90. Une seconde branche comprend deux résistances R5 et R7 en série et un potentiomètre P1. Enfin une troisième branche comprend une résistance R6 en série avec une sonde au silicium 91. Cet ensemble résistif est branché entre une borne 10 du connecteur du capteur et le collecteur d'un transistor PNP 92. Un point commun entre la résistance R4 et la thermistance 90 est relié à une entrée inverseuse d'un amplificateur opérationnel 93 dont l'entrée non-inverseuse est reliée à un point commun entre les résistances R5 et R7. Un condensateur C1 est monté entre l'entrée inverseuse de l'amplificateur 85 et sa sortie. Cette sortie est reliée à la base du transistor 92 par une résistance R2. La base du transistor 92 est reliée à la borne 9 du connecteur du capteur par une résistance R1 tandis que son émetteur est relié directement à cette borne et que son collecteur y est relié par une résistance R3.

Un point commun entre la résistance R6 et la sonde au silicium 91 est relié à l'entrée non-inverseuse d'un second amplificateur opérationnel 94 monté en amplificateur suiveur. Une sortie de ce second amplificateur 94 est reliée à l'entrée non-inverseuse d'un troisième amplificateur opérationnel 95 au moyen d'une résistance R8. L'amplificateur 95 est monté en amplificateur non-inverseur. Son entrée inverseuse est reliée à sa sortie par une résistance R10 et elle est également reliée à une borne 3 du connecteur du capteur par une résistance R11 en série avec un potentiomètre P2. Une entrée non-inverseuse de l'amplificateur 95 est reliée à la tension de référence +6V au moyen d'une résistance P9 et à un curseur mobile d'un potentiomètre P3 par une résistance R12. Des bornes fixes du potentiomètre P3 sont reliées respectivement à la tension de référence +6V et à la borne 10 du connecteur du capteur. Une borne 4 du connecteur du capteur est reliée à sa borne 10 tandis que sa borne 5 est en l'air. Ainsi le multiplexeur 31 se trouve dans un état selon lequel ses sorties 13, 3 sont reliées avec ses entrées 14, 5.

Selon le principe de fonctionnement de ce circuit, la thermistance 90 est chauffée électriquement et maintenue à température constante. On mesure l'apport d'énergie nécessaire pour maintenir cette température. L'apport d'énergie nécessaire dépend de trois facteurs principaux :
- la vitesse d'écoulement de l'air autour de la thermistance 90, que l'on cherche à mesurer ;
- la température ambiante. On obtient donc une compensation de température par la sonde au silicium 91. A la température de la thermistance 90, la variation du pont civiseur, constitué par la résistance R6 et la sonde au silicium 91, compense l'écart entre la température de la thermistance et la température ambiante ;
- la nature et la pression du gaz dont on mesure la vitesse. On supposera que ces facteurs restent inchangés.

En fonctionnement, l'amplificateur 93 et les composants qui lui sont associés maintiennent en équilibre le pont R4, thermistance 90, R5, R7 et par conséquent maintiennent constante la résistance de la thermistance 90. Compte tenu de la nature de celle-ci, sa température est donc constante. Après compensation par le pont diviseur R6, sonde au silicium 91, la tension est acheminée à l'amplificateur 94 pour réglage à 0 et fin d'échelle. La variation de tension n'étant pas proportionnelle à la vitesse de l'air, le signal est acheminé dans l'unité de traitement vers le circuit 32 réalisant une élévation à la puissance.

L'unité de traitement définit donc un circuit électronique capable, à partir d'un signal émis par l'un quelconque de plusieurs capteurs, de délivrer une tension continue proportionnelle à la valeur de la grandeur mesurée :

| | |
|---|---|
| - capteur d'intensité inductif | 1 mV/A |
| - capteur d'intensité à effet Hall | 1 mV/A |
| - capteur d'humidité | 1 mV/% HR |
| - capteur de température | 1 mV/°C |
| - capteur de lumière | 1 mV/lx avec facteur 10, 100 ou 1000 |
| - capteur de haute tension | 100 mV/KV |
| - capteur anémométrique | 10 mV/ms. |

Sur les figures 2 et 3, l'unité de traitement est montée sur une carte électronique 100 dans un boîtier 101. Ce boîtier inclut une pile d'alimentation 102 de type 6LR61 de 9V, un bouton de commande 103 destiné à commander l'ouverture de la pince ampèremétrique de certains capteurs.

Le boîtier 101 porte, sur une face latérale opposée à une face latérale recevant le bouton de commande 103, un bouton de réglage du zéro 104, une dioae électroluminescente 105 de contrôle de mise sous tension et de contrôle de l'état de la pile, un interrupteur marche/arrêt 106, et le commutateur 75 de gamme de mesure de lumière.

Naturellement, l'invention s'applique, non seulement aux capteurs décrits ci-dessus, mais à tout autre type de capteur.

## Revendications

1. Dispositif d'acquisition de mesures multifonction, caractérisé en ce qu'il comprend :
- une pluralité de capteurs (notamment 21 à 26) relatifs à plusieurs grandeurs physiques différentes, chacun comprenant des moyens d'identification (1 à 14) agencés pour fournir une première information d'identification, représentative de la nature de la grandeur physique concernée, et des moyens transducteurs agencés pour fournir une seconde information, représentative de la valeur de cette grandeur physique et fournie sous la forme d'une grandeur électrique ; et
- une unité de traitement (20) agencée pour coopérer avec l'un quelconque desdits capteurs (21 à 26), comprenant des moyens d'interprétation (1 à 14, 31) agencés pour interpréter ladite première information d'identification, et des moyens de traitement (32, 33, 35, 42, 44) agencés pour transformer ladite grandeur électrique en une grandeur électrique unique de référence en fonction de ladite première information d'identification.

2. Dispositif selon la revendication 1, dans lequel chaque capteur comprend un connecteur électrique agencé pour coopérer avec un connecteur électrique de l'unité de traitement, chaque connecteur comprenant plusieurs bornes, lesdits moyens d'identification (1 à 14) incluant un câblage spécifique desdites bornes du capteur, lesdits moyens d'interprétation incluant un câblage correspondant desdites bornes de l'unité de traitement (20).

3. Dispositif selon la revendication 1 ou la revendication 2, dans lequel lesdits moyens d'interprétation comprennent un multiplexeur analogique (31).

4. Dispositif selon l'une quelconque des revendications précédentes, dans lequel lesdits moyens de traitement incluent des moyens pour alimenter lesdits capteurs sous une tension ou un courant constant.

5. Dispositif selon l'une quelconque des revendications précédentes, dans lequel lesdits moyens de traitement incluent un amplificateur différentiel (44) pour prélever une tension fournie par un capteur à effet Hall.

6. Dispositif selon l'une quelconque des revendications précédentes, dans lequel lesdits moyens de traitement incluent une bascule monostable (36) pour coopérer avec un capteur d'humidité.

7. Dispositif selon l'une quelconque des revendications précédentes, dans lequel lesdits moyens de traitement incluent un amplificateur d'élévation à la puissance (32) pour coopérer avec un capteur anémométrique.

8. Dispositif selon l'une quelconque des revendications précédentes, dans lequel l'unité de traitement comprend :
- un boîtier principal (20) logeant lesdits moyens d'interprétation (1 à 14, 31) et lesdits moyens de traitement (32, 33, 35, 42, 44) ;
- un boîtier complémentaire ou sabot (30) relié de façon enfichable à une extrémité inférieure dudit boîtier principal (20), portant un connecteur agencé pour délivrer des signaux de sortie du boîtier principal (20), et présentant un espace intérieur pour loger un dispositif d'interface entre le boîtier principal (20) et le connecteur.
